(19)

Europäisches Patentamt
European Patent Office
Office européen des brevets

(11) **EP 1 176 719 B1**

(12) **EUROPEAN PATENT SPECIFICATION**

(45) Date of publication and mention
of the grant of the patent:
**15.09.2010   Bulletin 2010/37**

(51) Int Cl.:
***H03K 3/354*** *(2006.01)*

(21) Application number: **01113644.7**

(22) Date of filing: **19.06.2001**

(54) **Oscillation circuit, electronic circuit, semiconductor device, electronic equipment and timepiece**

Oszillatorschaltung, elektronische Schaltung, Halbleiteranordnung, elektronisches Gerät und Uhrwerk

Circuit d'oscillateur, circuit électronique, dispositif semi-conducteur, appareil électronique et pièce d'horlogerie

(84) Designated Contracting States:
**CH DE FR GB LI**

(30) Priority:  **19.06.2000   JP 2000183384**

(43) Date of publication of application:
**30.01.2002   Bulletin 2002/05**

(73) Proprietor: **Seiko Epson Corporation
Tokyo 163-0811 (JP)**

(72) Inventors:
• **Nakamiya, Shinji,
Seiko Epson Corporation
Suwa-shi,
Nagano-ken 392-8502 (JP)**

• **Kadowaki, Tadao,
Seiko Epson Corporation
Suwa-shi,
Nagano-ken 392-8502 (JP)**

(74) Representative: **MERH-IP
Matias Erny Reichl Hoffmann
Paul-Heyse-Strasse 29
80336 München (DE)**

(56) References cited:
**EP-A- 0 851 323     EP-A- 0 905 877
US-A- 3 979 698**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

This invention relates to an oscillation circuit, an electronic circuit using the oscillation circuit, and a semiconductor device, electronic equipment and timepiece.

Background

Oscillation circuits are widely employed in the art in devices such as portable timepieces, portable telephones, and computer terminals. It is necessary to design such portable items of electronic equipment in such a manner that they are economical in their power consumption and have longer battery lives.

This crystal oscillation circuit comprises an inverting amplifier and a feedback circuit that is provided with a crystal oscillator. The inverting amplifier comprises a pair of transistors where the gate of each of these transistors is used as an input side and the drain thereof is used as an output side, by way of example. In this case, the drain sides of these two transistors are connected together and the source sides thereof are connected to ground and a power voltage side, respectively.

If the power voltage is applied to the inverting amplifier in the crystal oscillation circuit of this configuration, the phase of the output of the inverting amplifier is inverted through 180 degrees and the thus inverted signal is fed back to the gate of each transistor as an input. The transistors configuring the inverting amplifier are turned on and off alternately by the operation of this feedback, the oscillation output of the crystal oscillation circuit gradually increases, and thus the oscillator starts to oscillate stably.

However, the absolute value of a voltage $V_{reg}$ applied to the inverting amplifier in this prior-art crystal oscillation circuit is set to be greater than the total of the absolute values of the threshold voltages $V_{TP}$ and $V_{TN}$ of the transistors in this circuit, as follows:

$$|V_{reg}| > |V_{TP}| + |V_{TN}| \tag{1}$$

The current inventors have discovered that this is the cause of a short-circuiting current $I_s$ that flows from the high potential side to the low potential side within the inverting amplifier, which causes a problem when trying to reduce the power consumption of the entire circuit.

Furthermore, the current inventors have developed an oscillation circuit in which the first and second semiconductor switching elements included in an inverting amplifier are prevented from being on simultaneously to limit a short-circuiting current flowing through the inverting amplifier when the oscillation circuit is driven (see Japanese Patent Application Laid-Open No. 9-87763). The oscillation circuit can reduce the short-circuiting current that flows through the inverting amplifier and oscillate with low power consumption.

US 3,979,698 A discloses an oscillation circuit comprising a first semiconductor switching element and a second semiconductor switching element included in an inverting amplifier, wherein either the first or the second semiconductor switching elements is connected in parallel to a constant current source, and a shortage of power necessary for stabilizing oscillation is compensated for by power from the constant current source, wherein the first and second semiconductor switching elements included in the inverting amplifier are prevented from being on simultaneously to limit a short-circuiting current flowing through the inverting amplifier when the oscillation circuit is driven, and wherein an OFF region in which the first and second semiconductor switching elements are turned off so that they are prevented from being on simultaneously includes a sub-threshold region in which a sub-threshold current flows.

Summary

An objective of this invention is to reduce further the short-circuiting current that flows through the inverting amplifier and thus provide an oscillation circuit that can oscillate with low power consumption, an electronic circuit, a semiconductor device, electronic equipment and timepiece.

This objective is achieved by an oscillation circuit as claimed in claim 1. Preferred embodiments of the invention are defined in the dependent claims.

This configuration makes it possible to limit the short-circuiting current flowing through the inverting amplifier, making it possible to provide an oscillation circuit that can oscillate with low power consumption.

At least one of the first and second semiconductor switching elements is connected in parallel to a plurality of constant current sources, each constant current source supplying a different constant current; and a selection circuit is provided for selecting a constant current source from the plurality of constant current sources, wherein a shortage of power necessary for stabilizing oscillation is compensated for by power from the selected constant current source.

This configuration makes it possible to select the optimum constant current source which can supply an additional current to compensate for any degree of shortage of power caused by different levels of fluctuations of the constant voltages in oscillation circuits produced in great quantities. Therefore, this configuration makes it possible to supply an additional current to offset a shortage of power at any time even if power necessary for stabilizing oscillation may change due to different levels of fluctuations of the constant voltages in oscillation circuits produced in great quantities. In this manner, it is possible to provide an oscillation circuit that can oscillate with low power consumption.

The first and second semiconductor switching elements included in the inverting amplifier are prevented from being on simultaneously to limit a short-circuiting current flowing through the inverting amplifier when the oscillation circuit is driven. This makes it possible to provide an oscillation circuit that can oscillate with low power consumption.

According to an embodiment of this invention, it is preferable to provide an oscillation circuit in which a target absolute value of the power voltage of the inverting amplifier is set to be between an absolute value of a minimum power voltage of the inverting amplifier necessary for stabilizing oscillation and an absolute value of a first power voltage that is smaller than the absolute value of the minimum power voltage by a range of fluctuations of power voltages of inverting amplifiers in oscillation circuits which are produced in large quantities and wherein the selection circuit selects a constant current based on power voltages of inverting amplifiers in oscillation circuits which are produced in large quantities, and a shortage of power necessary for stabilizing oscillation is offset by power from the selected constant current source.

Furthermore, according to an embodiment of this invention it is preferable that a first group of constant current sources is connected in parallel to the first semiconductor switching element, each of the plurality of constant current sources supplying a different constant current, and a second group of constant current sources connected in parallel to the second semiconductor switching element, each of the second group of constant current sources supplying a different constant current. The selection circuit selects a constant current source from each of the groups of constant current sources, and a shortage of power necessary for stabilizing oscillation is offset by power from the selected constant current sources.

This configuration makes it possible to drive an oscillation circuit at a voltage as low as a voltage necessary for stabilizing oscillation even if the constant voltages vary among oscillation circuits which are produced in large quantities, and making it possible to reduce the power consumption of the oscillation circuit effectively.

According to one embodiment of this invention, the sum of the absolute value of the threshold voltage of the first semiconductor switching element and the absolute value of the threshold voltage of the second semiconductor switching element may be set to be greater than or equal to the absolute value of the power voltage of the inverting amplifier, to limit a short-circuiting current flowing through the inverting amplifier.

The oscillation circuit of this invention may further comprise a feedback circuit having a crystal oscillator connected between the output and input sides of the inverting amplifier, for causing the phase of an output signal from the inverting amplifier to invert and feeding the thus inverted signal back to the inverting amplifier as an input;

wherein the inverting amplifier comprises a first circuit including the first semiconductor switching element, and a second circuit including the second semiconductor switching element;

wherein the first semiconductor switching element is connected to the side of a first potential and is driven to be turned on and off by the feedback input, to excite the crystal oscillator;

wherein the second semiconductor switching element is connected to the side of a second potential that differs from the first potential and is driven to be turned on and off by the feedback input at a timing that differs from that of the first semiconductor switching element, to excite the crystal oscillator; and

wherein the sum of the absolute value of the threshold voltage of the first semiconductor switching element and the absolute value of the threshold voltage of the second semiconductor switching element is set to be greater than or equal to the absolute value of the power voltage of the inverting amplifier, to limit a short-circuiting current flowing through the inverting amplifier.

In this case, when a voltage is applied to the inverting amplifier in the crystal oscillation circuit, excitation of the crystal oscillator starts. The phase of the output of the inverting amplifier is inverted by the feedback circuit and is fed back as an input. The operations of inverting, amplifying, and outputting this feedback input signal by the inverting amplifier are repeated.

During this time, the first and second semiconductor switching elements that configure the inverting amplifier are driven to be turned on and off at mutually different timings by this feedback input, to excite the crystal oscillator.

As stated above, the sum of the absolute values of the threshold voltages of the first and second semiconductor switching elements can be set to be greater than or equal to the absolute value of the power voltage of the inverting amplifier. This prevents the first and second semiconductor switching elements from being driven to turn on simultaneously when the circuit is operating, and, as a result, the short-circuiting current flowing through the inverting amplifier can be greatly reduced, making it possible to reduce the power consumption.

In particular, by forming the first and second transistors in such a manner that the threshold voltage conditions

# EP 1 176 719 B1

are satisfied, there is no further need for means for dealing with this short-circuiting current, making it unnecessary to use special circuit components for counteracting this short-circuiting current. This makes it possible to reduce the power consumption of the crystal oscillation circuit without adversely affecting the degree of integration of the entire circuit.

Note that it is necessary to set each of the absolute values of the threshold voltages of these first and second semiconductor switching elements to be less than the absolute value of the power voltage of the inverting amplifier.

In this invention, there is provided an oscillation circuit in which the sum of the absolute values of the threshold voltages of the first and second semiconductor switching elements is preferably set to be greater than or equal to the absolute value of the power voltage of the inverting amplifier to satisfy the following formula

$$|V_{reg}| \leq |V1| + |V2|$$

where the absolute value of the threshold voltage of the first semiconductor switching element is $|V1|$: the absolute value of the threshold voltage of the second semiconductor switching element is $|V2|$; and the absolute value of the power voltage of the inverting amplifier is $|V_{reg}|$, and

wherein the absolute values of the threshold voltages of the first and second semiconductor switching elements are set to be smaller than the absolute value of the power voltage of the inverting amplifier as represented by the following formulae

$$|V_{reg}| > |V1|$$

and

$$|V_{reg}| > |V2|.$$

According to another embodiment of this invention, the oscillation circuit may further comprise a bias circuit for applying a first direct current bias voltage and a second direct current bias voltage to gates of the first semiconductor switching element and the second semiconductor switching element, respectively;

wherein the first and second direct current bias voltages shift the values of the direct current potentials of feedback inputs that are input from the inverting amplifier to the gates of the first and second semiconductor switching elements, to prevent the first and second semiconductor switching elements from being on simultaneously.

The oscillation circuit may further comprise:

a feedback circuit having a crystal oscillator connected between the output and input sides of the inverting amplifier, for causing the phase of an output signal from the inverting amplifier to invert and feeding the thus inverted signal back to the inverting amplifier as an input; and
a bias circuit for applying a direct current bias voltage to the inverting amplifier;
wherein the inverting amplifier comprises:

a first circuit connected to the side of a first potential and comprising the first semiconductor switching element; and
a second circuit connected to the side of a second potential that differs from the first potential and comprising the second semiconductor switching element;

wherein the first semiconductor switching element is connected to the side of the first potential and is driven to be turned on and off by the feedback input that is input to a gate, to excite the crystal oscillator;
wherein the second semiconductor switching element is connected to the side of the second potential and is driven to be turned on and off by the feedback input that is input to a gate at a timing that differs from that of the first semiconductor switching element, to excite the crystal oscillator;
wherein the bias circuit comprises:

a first bias circuit for applying a first direct current bias voltage to the gate of the first semiconductor switching element; and
a second bias circuit for applying a second direct current bias voltage to the gate of the second semiconductor switching element; and

wherein the first and second direct current bias voltages shift the values of the direct current potentials of feedback inputs that are input from the inverting amplifier to the gates of the first and second semiconductor switching elements, to prevent the first and second semiconductor switching elements from being on simultaneously.

By employing the above configuration, there is no common-on time at which both of the first and second semiconductor switching elements are on, while the first and second semiconductor switching elements that configure the inverting amplifier are driven to be turned on and off at mutually different timings by this feedback input, to excite the crystal oscillator. Therefore the short-circuiting current flowing through the inverting amplifier can be greatly reduced, making it possible to achieve a crystal oscillation circuit that can oscillate stably at a low power consumption.

In particular, the short-circuiting current, of the inverting amplifier can be reduced, even when the absolute values of the threshold voltages of the first and second semiconductor switching elements are made small. The power voltage of the crystal oscillation circuit can therefore be reduced by that amount, making it possible to reduce the power consumption of the oscillation circuit even further.

In this case, the first direct current bias voltage may be set to the first potential and the second direct current bias voltage may be set to the second potential.

The direct current potentials of the inputs fed back to the gates of the first and second semiconductor switching elements can be shifted towards the respective first and second potential sides of the power source by the application of the thus-set direct current bias voltages. This makes it possible to provide a crystal oscillation circuit which has a simple circuit configuration and which can reduce the short-circuiting current of the inverting amplifier.

With an electronic equipment comprising the electronic circuit of this invention the power consumption can be decreased, in particular with an item of portable electronic equipment, such as a portable telephone or computer terminal, making it possible to reduce the consumption thereof of power from an internal battery or secondary battery.

Where this invention is applied to a timepiece a portable timepiece can be implemented that has a low power consumption, which enables the design of a timepiece that is itself smaller and uses an even smaller battery. Alternatively, the battery life thereof could be extended even when a battery of the same capacity is used.

Brief Description of the Drawings

| Fig. 1 | is a circuit diagram of an example of a crystal oscillation circuit; |
|---|---|
| Fig. 2 | is a timing chart of a prior-art circuit; |
| Fig. 3 | is a timing chart of the circuit of Fig. 1; |
| Fig. 4 | is an illustrative drawing of the relationship between the threshold voltages, the power source potential, and the ground potential of the prior-art circuit; |
| Fig. 5 | is an illustrative drawing of the relationship between the threshold voltages, the power source potential, and the ground potential of the example; |
| Fig. 6 | is a graph of the $V_{GS}$-$I_D$ characteristic of an enhancement-mode transistor; |
| Fig. 7 | is a circuit diagram of a second embodiment of the crystal oscillation circuit in accordance with this invention; |
| Fig. 8 | is a timing chart of the second embodiment; |
| Fig. 9 | illustrates ON and OFF regions; |
| Fig. 10 | illustrates $V_G$-$I_D$ characteristics; |
| Fig. 11 | illustrates $V_G$-$I_D$ characteristics; |
| Fig. 12 | illustrates $V_G$-$I_D$ characteristics; |
| Fig. 13 | is a circuit diagram of a first embodiment of the crystal oscillation circuit according to the present |

invention; and

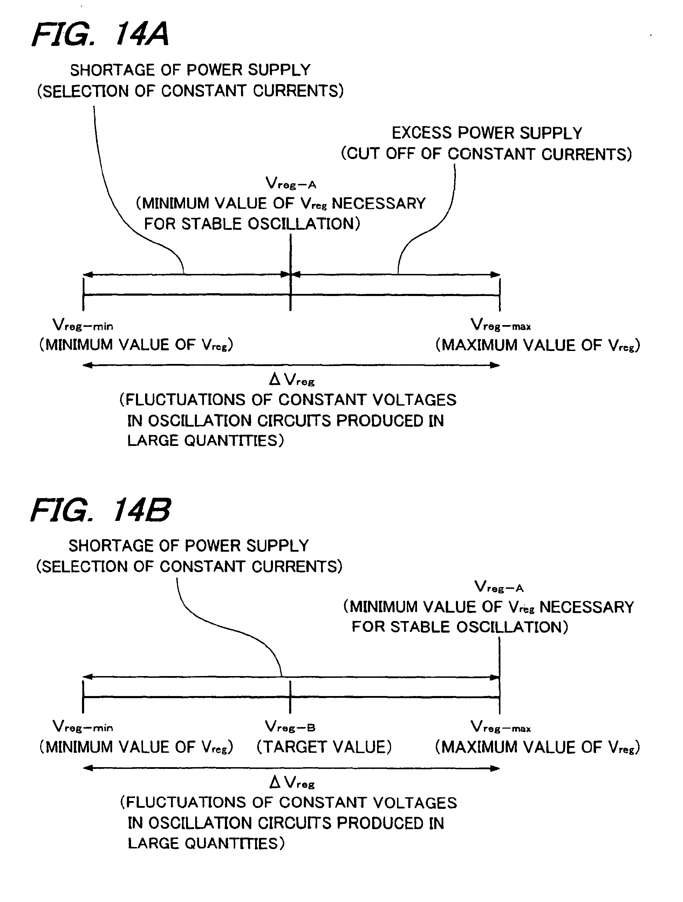

Figs. 14A and 14B    illustrate target constant voltages.

Detailed Description

Embodiments of this invention will be described below with reference to the accompanying drawings.

1. Example

1.1 Basic Arrangements

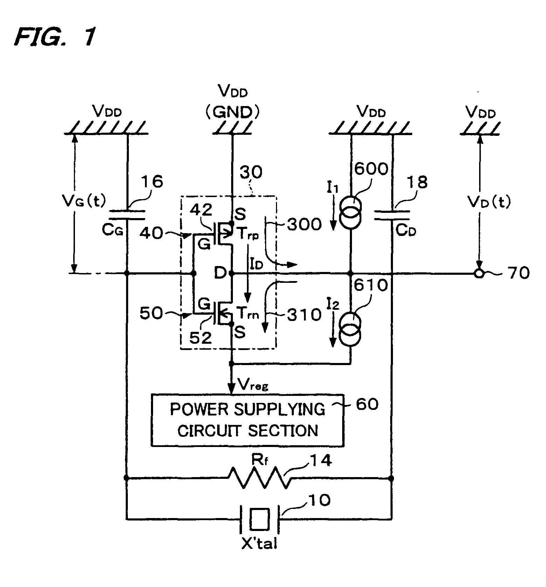

An example of a crystal oscillation circuit is shown in Fig. 1. The crystal oscillation circuit of this example is one that is used in a quartz wristwatch.

This crystal oscillation circuit comprises an inverting amplifier 30 and a feedback circuit. This feedback circuit comprises a crystal oscillator 10, a resistor 14, and phase-compensation capacitors 16 and 18. It inverts the phase of an output $V_{D(t)}$ of the inverting amplifier 30 by 180 degrees and inputs the inverted signal as a gate signal $V_{G(t)}$ to the gate of the inverting amplifier 30 as feedback.

The configuration of the inverting amplifier 30 is such that it is connected between a first potential side and a second potential side that is at a lower potential, and it is powered by the potential difference between these two potentials. In this particular case, the first potential is set to the ground potential $V_{DD}$ and the second potential is set to a negative power source potential $V_{reg}$ that is supplied from a power supplying circuit section 60.

The inverting amplifier 30 comprises a first circuit 40 and a second circuit 50.

The first circuit 40 comprises a p-type field-effect transistor 42 that functions as a first semiconductor switching element. The source of this transistor 42 is connected to ground, the drain thereof is connected to an output terminal 70 side, and the feedback signal $V_{G(t)}$ is applied to the gate thereof.

The second circuit 50 comprises an n-type field-effect transistor 52 that functions as a second semiconductor switching element. The source of this transistor 52 is connected to the power source terminal side of the power supplying circuit section 60, the drain thereof is connected to the output terminal 70 side (in this case, it is actually connected to the drain of the transistor 42), and the feedback signal $V_{G(t)}$ is applied to the gate thereof.

A transistor that is both a p-type as well as an enhancement-mode field-effect transistor is used as the transistor 42, and a transistor that is both an n-type as well as an enhancement-mode field-effect transistor is used as the transistor 52. The values of the threshold voltage $V_{TP}$ of the transistor 42 and the threshold voltage $V_{TN}$ of the transistor 52 are such that the total absolute value thereof is greater than or equal to the absolute value of the power voltage applied to the inverting amplifier 30 (in this example, the power voltage is $V_{reg}$, which is the potential difference between the ground potential and the power source potential, because the ground potential $V_{DD}$ is set to zero), as given by the following equation:

$$|V_{reg}| \leq |V_{TP}| + |V_{TN}| \tag{2}$$

In addition, the absolute values of the threshold voltages of the transistors 42 and 52 are each set to be less than the absolute value of the power voltage, as follows:

$$|V_{reg}| > |V_{TP}|$$

$$|V_{reg}| > |V_{TN}| \tag{3}$$

This ensures that the short-circuiting current that flows through the inverting amplifier 30 of the crystal oscillation circuit of this example is greatly reduced, making it possible to reduce the power consumption thereof.

The reasons for this are discussed below.

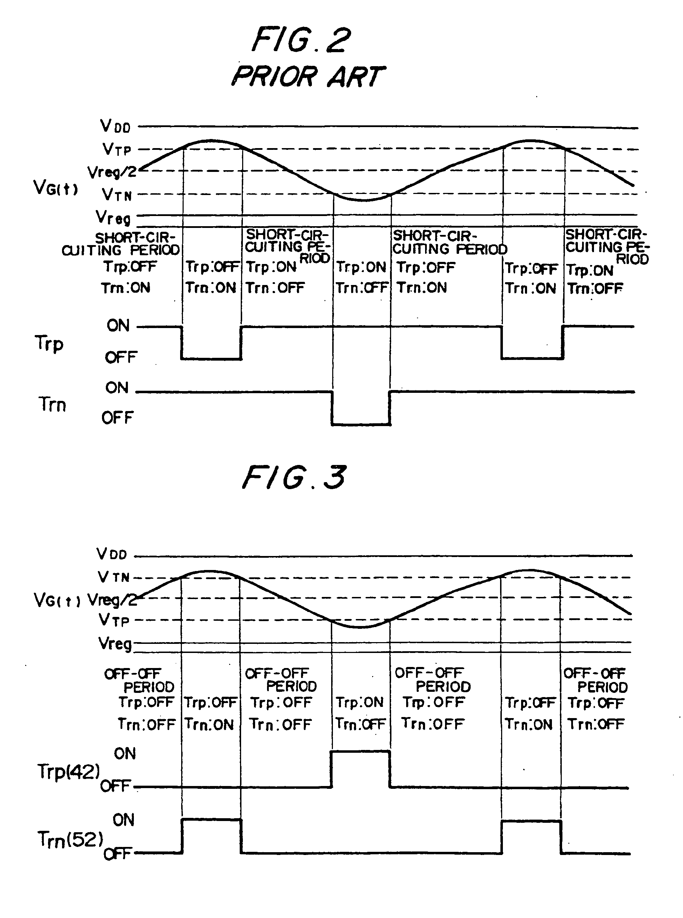

A timing chart of a prior-art crystal oscillation circuit is shown in Fig. 2 and a timing chart of the crystal oscillation circuit of this example is shown in Fig. 3. In each of these figures, the elapsed time from the application of the power voltage $V_{reg}$ from the power supplying circuit section 60 is plotted along the horizontal axis, with the feedback input $V_{G(t)}$

to the inverting amplifier 30 and the on/off state of the transistors 42 and 52 being plotted along the vertical axis.

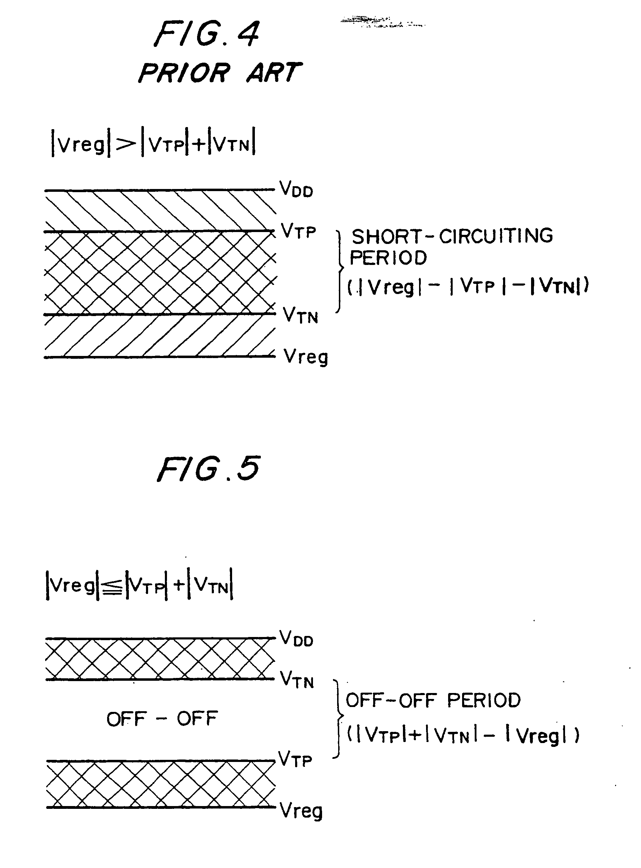

As previously mentioned, the threshold voltages of the two transistors that configure the inverting amplifier of the prior-art crystal oscillation circuit are set in such a manner that the above Equation (1) is satisfied. The relationships between the threshold voltages of these transistors, the ground potential $V_{DD}$, and the power source potential $V_{reg}$ in this case are shown graphically in Fig. 4. In other words, if the value of the feedback input $V_{G(t)}$ to the inverting amplifier is set to within the following range with respect to the potentials of the threshold voltages $V_{TP}$ and $V_{TN}$:

$$V_{TP} > V_{G(t)} > V_{TN}$$

both transistors are turned on and a short-circuiting period is established thereby.

Therefore, while these transistors are being turned on and off alternately by the feedback signal $V_{G(t)}$, a time during which both of the transistors are driven to be on occurs periodically, as shown in Fig. 2, so that a short-circuiting current flows from the high potential ($V_{DD}$) to the low potential ($V_{reg}$) side, which is an impediment to any reduction in the power consumption.

In contrast thereto, the threshold voltages of the transistors 42 and 52 in this example are set in such a manner that the above Equations (2) and (3) are satisfied. The relationships between the threshold voltages, the ground potential $V_{DD}$, and the power source potential $V_{reg}$ in this case are shown in Fig. 5. That is to say, if the value of the feedback input $V_{G(t)}$ to the inverting amplifier 30 is set to be within the following range with respect to the potentials of the threshold voltages $V_{TP}$ and $V_{TN}$:

$$V_{TN} > V_{G(t)} > V_{TP}$$

the two transistors 42 and 52 are turned off firmly so that there is no common-on time during which both of the transistors 42 and 52 are on, as there is in the prior art.

In other words, as shown in Fig. 3, while the transistors 42 and 52 are being driven on and off alternately by the feedback signal $V_{G(t)}$, there is no period of time during which both of the transistors 42 and 52 are on, so that the short-circuiting current that causes problems in the prior art is greatly reduced and thus the power consumption of the crystal oscillation circuit can be reduced.

In particular, this method of countering the short-circuiting current of the inverting amplifier 30 of this example can be implemented without increasing the number of circuit components.

Furthermore, the absolute values of the threshold voltages of the transistors 42 and 52 of this example are each set to be less than the absolute value of the power voltage $V_{reg}$, as shown by Equations (3). This makes it possible to implement reduced power consumption while maintaining a stable oscillation of the crystal oscillation circuit.

In other words, the absolute value of the amplitude of the feedback signal $V_{G(t)}$ of the inverting amplifier 30 in the crystal oscillation circuit does not exceed the absolute value of the power voltage $V_{reg}$ of the inverting amplifier. This means that the transistors 42 and 52 can be driven to turn on and off alternately in a stable manner by setting the absolute values of the threshold voltages of the transistors 42 and 52 to satisfy Equations (3).

Experiments performed by the present inventors have verified that a satisfactory oscillation state can be maintained and the power consumption can be reduced when an oscillation circuit is driven by a power voltage $V_{reg}$ of an absolute value of 0.9 volts, even when the sum of the absolute values of the threshold voltages of the transistors 42 and 52 varies within the following range:

$$1.4 \text{ volts} > |V_{TP}| + |V_{TN}| > 0.9 \text{ volts}$$

In addition, the off-leakage currents of the transistors 42 and 52 in this example are reduced, for reasons that will be described below, making it possible to further reduce the power consumption of the entire circuit.

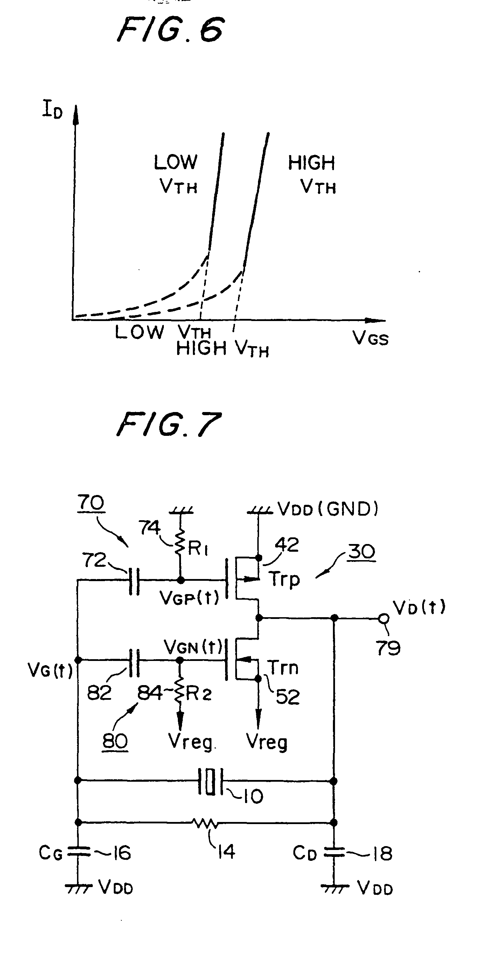

A characteristic graph of the relationship between the drain current $I_D$ of an enhancement-mode transistor and the voltage $V_{GS}$ between the gate and source thereof is shown in Fig. 6. It can be seen from this graph that the $I_D$-$V_{GS}$ characteristic curve of an enhancement-mode transistor shifts towards the left and the off-leakage current thereof increases, as shown by the broken lines in the figure, as the threshold voltage is made lower (in this graph, the transistor turns off when $V_{GS}$ is equal to or less than the threshold voltage $V_{TH}$, but at this region, the current $I_D$ is yet to flow through the transistor as the off-leakage current, as shown by the broken lines in the figure).

Therefore, if the threshold voltages of the transistors 42 and 52 are set to be low, as in the prior-art oscillation circuit, the off-leakage current at and below the threshold voltage is larger, and the power consumption is increased by that amount.

In contrast thereto, since the threshold voltages of the transistors 42 and 52 in this example are set to large values, as shown by Equation (2), the values of the off-leakage currents that flow through the transistors 42 and 52 are greatly reduced, and thus the power consumption of the entire circuit can be reduced.

1.2 OFF region and Arrangement for Stable Oscillation

The description now turns to (1) the specific definition of the OFF region for Pch- and Nch-transistors 42, 52 and (2) stable oscillation in the inverting amplifier 30 at the OFF region of the Pch- and Nch-transistors.

(1) First of all, the OFF region for the Pch- and Nch-transistors 42, 52 will be described.

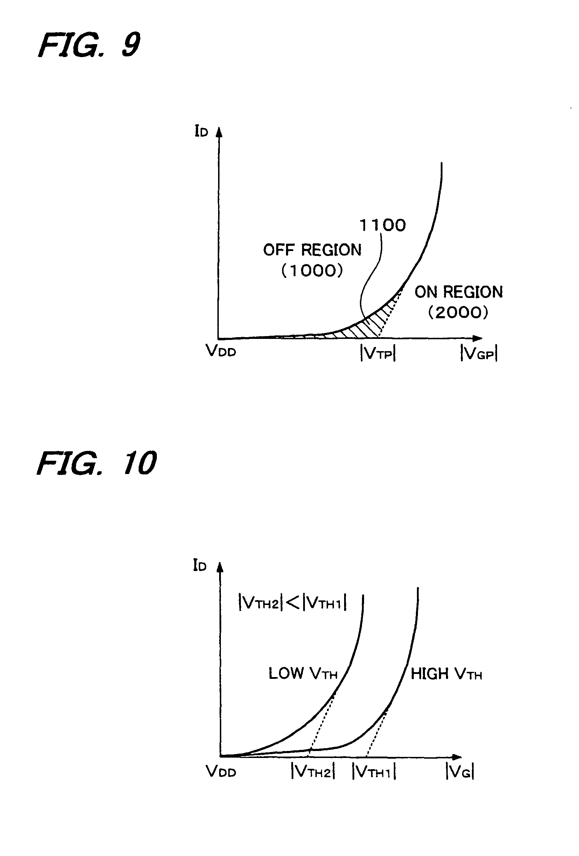

Referring to Fig. 9, it is assumed herein that the gate voltage of the Pch-transistor 42 is $V_{GP}$; the source voltage thereof is $V_{SP}$; and the threshold voltage is $V_{TP}$. If $V_{DD}=G_{ND}$, $|V_{SP}|=V_{DD}=0$. Thus, the difference of potential $V_{GSP}$ between the gate and source is represented by the following formula:

$$V_{GSP} = |V_{GP}| - |V_{SP}| = |V_{GP}|.$$

The OFF region for the Pch-transistor 42 is then defined as regions 1000 and 1100 of $|V_{GP}| < |V_{TP}|$ shown in Fig. 9, which satisfy the following formula (a):

$$V_{GSP} = |V_{GP}| < |V_{TP}|...(a).$$

Conversely, the ON region becomes a region 2000 of $|V_{GP}| \geq |V_{TP}|$.

The threshold voltage $V_{TP}$ is defined as the gate voltage $V_{GP}$ when the conduction type of the silicon crystal surface is completely inverted and represented by the following formula:

$$V_{TP} = 2\Phi_E + [2 \cdot \varepsilon_S \cdot q \cdot N_A \cdot (2\Phi_E)]^{1/2} / (\varepsilon_S /d)...(b)$$

where $\Phi_E$ is a Fermi potential, $\varepsilon_S$ is $\varepsilon si$ (the relative dielectric constant of silicon) multiplied by $\varepsilon 0$ (the dielectric constant of vacuum), q is an electron charge, $N_A$ is a concentration of a substrate and d is the thickness of an oxide film.

The sub-threshold region 1100 forming a part of the OFF region will be described.

In the OFF region satisfying the above formula (a), the conduction type of the silicon crystal surface is only slightly inverted. If there is a gradient in the carrier density, the carriers diffuse from one region having a high density to another region having a low density, so that the drain current $I_D$ (OFF current in transistor) flows through the OFF region. Such a drain current is called a sub-threshold current and is represented by the following formula:

$$I_D = \alpha \cdot exp[q \cdot (V_{GP} - V_{TP})/k \cdot T] ...(c)$$

Where $\alpha$ is a coefficient; k is Botzmann's constant; and T is an absolute temperature.

Referring to Fig. 9, the region 1100 through which such a drain current flows is called a sub-threshold region and forms a part of the OFF region.

The OFF region for the Nch-transistor 52 is similar to that for the Pch-transistor 42 and will not further be described herein.

The description of the OFF region for each of said transistors 42 and 52 is applicable to each example which will be described.

(2) The description now turns to the continuity of oscillation in the ON/OFF region.

(2-1) Even if the Pch- and Nch-transistors 42, 52 are simultaneously turned off in the drive region of the inverting amplifier 30, the sub-threshold current $I_D$ (OFF current in transistor) flows through the sub-threshold region 1100 of the above item (1). Thus, oscillation may continue by the power supplied from the power source $V_{reg}$ corresponding to the current $I_D$.

(2-2) Furthermore, the present example uses a high value Q which is an index representing the degree of easiness in mechanical oscillation. The value Q increases inertial oscillation in the crystal oscillator 10. In the sub-threshold region of the above item (1), therefore, it is possible to maintain stable oscillation with a little power being supplied from the power supply circuit 60. The value Q is represented by the following formula:

$$Q = \alpha/Rxt$$

where Rxt is a component of resistance in the crystal oscillator; and $\alpha$ is a coefficient.

It is desirable that the value Q is equal to or higher than 10,000.

1.3 Arrangement for Further Reduction of Power Consumption

In order to further reduce the power consumption and satisfy the following formulae, the threshold voltages $V_{TP}$ and $V_{TN}$ of the transistors 42 and 52 should not be reduced. The constant voltage $V_{reg}$ should be reduced to its lower limit.

$$|V_{reg}| \leq |V_{TP}| + |V_{TN}| \qquad \qquad \text{...(2)}$$

$$|V_{reg}| > |V_{TP}|, \ |V_{reg}| > |V_{TN}| \qquad \qquad \text{...(3)}$$

In other words, as shown in Fig. 10, the drain current $I_D$ at the sub-threshold region 1100 increases exponentially when the threshold voltage decreases as it is apparent from the formula (c). Therefore, it is undesirable to reduce the threshold voltage.

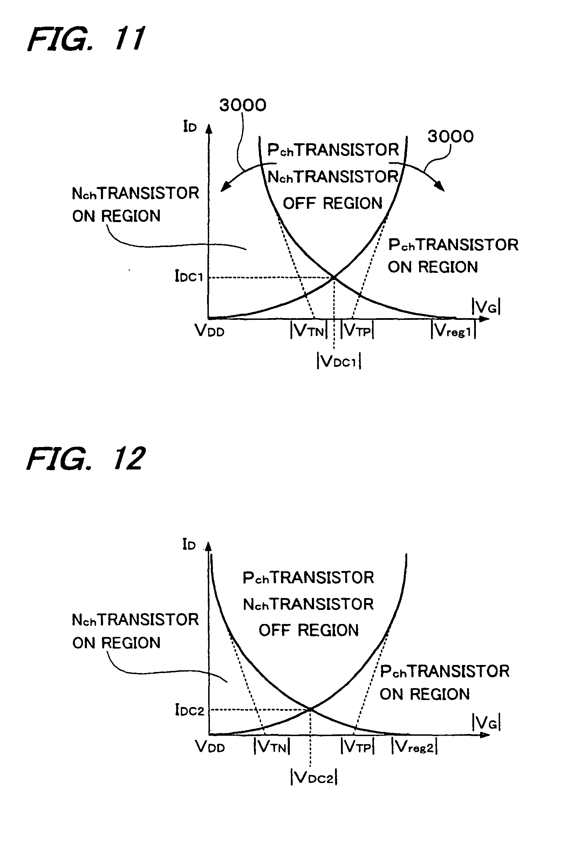

Figs. 11 and 12 show the changes in only the $V_{reg}$. The relationship between $V_{reg1}$ and $V_{reg2}$ in Figs. 11 and 12 is $|V_{reg1}| > |V_{reg2}|$. (The threshold voltage is the same in Figs. 11 and 12).

As shown in Fig. 11, a curve $V_G$ - $I_D$ is shifted in a direction of arrow 3000 when $|V_{reg}|$ decreases.

Comparing the drain currents $I_{DC}$ relative to the DC bias voltage $V_{DC}$ in the inverting amplifier 30 in Figs. 11 and 12, it is apparent that $I_{DC1} > I_{DC2}$. Therefore, it is possible to reduce the current consumption when the absolute value of the constant voltage $|V_{reg}|$ is reduced.

This raises a problem with a design devised for reducing the current to the maximum as in Fig. 12. The constant and threshold voltages may vary among oscillation circuits that are produced in large quantities.

In this way, the constant voltage $V_{reg2}$ may be reduced to a level lower than the target level and the threshold voltages $V_{TP}$ and $V_{TN}$ may exceed the target levels. As it is apparent from the aforementioned formula (c), the drain current at the sub-threshold region may too be reduced making oscillation unstable.

For example, as shown in Fig. 14A it is assumed that the minimum constant voltage required for stabilizing oscillation is $V_{reg-A}$; and the range of fluctuations of the constant voltages in the oscillation circuits which are produced in large quantities is $\Delta V_{reg}$. If the target value of the constant voltage is the aforementioned minimum constant voltage $V_{reg-A}$, the values of the constant voltages in the actual products fluctuate between

$$\text{Maximum } V_{reg-min} = V_{reg-A} - (\Delta V_{reg}/2)$$

and

$$\text{Minimum } V_{reg-max} = V_{reg-A} + (\Delta V_{reg}/2).$$

Therefore, it is impossible to stabilize oscillation if the constant voltages vary among oscillation circuits which are produced in large quantities and when the constant voltage $V_{reg}$ becomes smaller than the target level $V_{reg-A}$.

To overcome such a problem, this example uses such an arrangement of circuit as shown in Fig. 1.

The circuit supplies an additional current from constant current sources 600 and 610 connected in parallel to the respective transistors 42 and 52, in order to offset a shortage of power necessary for stabilizing oscillation caused by the reduction of the drain current $I_D$ at the sub-threshold region due to the fluctuations of the constant voltages in oscillation circuits produced in great quantities.

With the Nch-transistor 52, the operating current at the sub-threshold region becomes equal to the sum of the sub-threshold current $I_D$ of the transistor 52 and the current I2 of the constant current source 610. With the Pch-transistor 42, conversely, the operating current at the sub-threshold region becomes equal to the sum of the sub-threshold current $I_D$ of the transistor 42 and the current I1 of the constant current source 600.

Thus, oscillation may be stabilized even though the actual value $V_{reg}$ becomes smaller than the target value $V_{reg-A}$ set in the designing process due to the fluctuations of the constant voltages in oscillation circuits that are produced in large quantities. Furthermore, oscillation may be stabilized even though the values $V_{TP}$ and $V_{TN}$ are increased to reduce the drain current at the sub-threshold region.

2. First Embodiment

2.1 Modification of Constant Voltage to be designed

There are many types of fluctuations in $V_{reg}$, $V_{TP}$ and $V_{TN}$. For example, $V_{reg}$ may be increased or $V_{TP}$ and $V_{TN}$ may be reduced. The drain current at the sub-threshold region may be sufficiently high, so that the currents from the constant current sources 600 and 610 become unnecessary for stable oscillation.

For example, when the target constant voltage is equal to the aforementioned minimum constant voltage $V_{reg-A}$ as shown in Fig. 14A, the constant voltage $V_{reg}$ may be higher than the target level $V_{reg-A}$ resulting in excess power supply. In such a case, even though all the constant currents are cut off, it is impossible to reduce the power consumption.

In order to overcome the above problem, the present embodiment designs a product so that the target constant voltage is equal to $V_{reg-B}$, for example, as shown in Fig. 14B.

More particularly, the target constant voltage $V_{reg-B}$ is set to be between the absolute value of the minimum constant voltage required for stable oscillation and the absolute value of the first constant voltage $V_{reg-MIN}$ smaller than the absolute value of said minimum constant voltage by the range of fluctuations $\Delta V_{reg}$ of the constant voltages in oscillation circuits which are produced in large quantities. In this embodiment, the desired value is set

$$\text{Target value } V_{reg-B} = (\text{Minimum constant voltage } V_{reg-A}) - (\Delta V_{reg}/2).$$

Further, the present embodiment takes an arrangement for supplying an additional current from the constant current sources 600 and 610 connected in parallel to the respective transistors 42 and 52, in order to offset a shortage of power necessary for stabilizing oscillation.

In such a manner, it is possible to stabilize oscillation and reduce the power consumption even if the constant voltages $V_{reg}$ vary among oscillation circuits which are produced in large quantities.

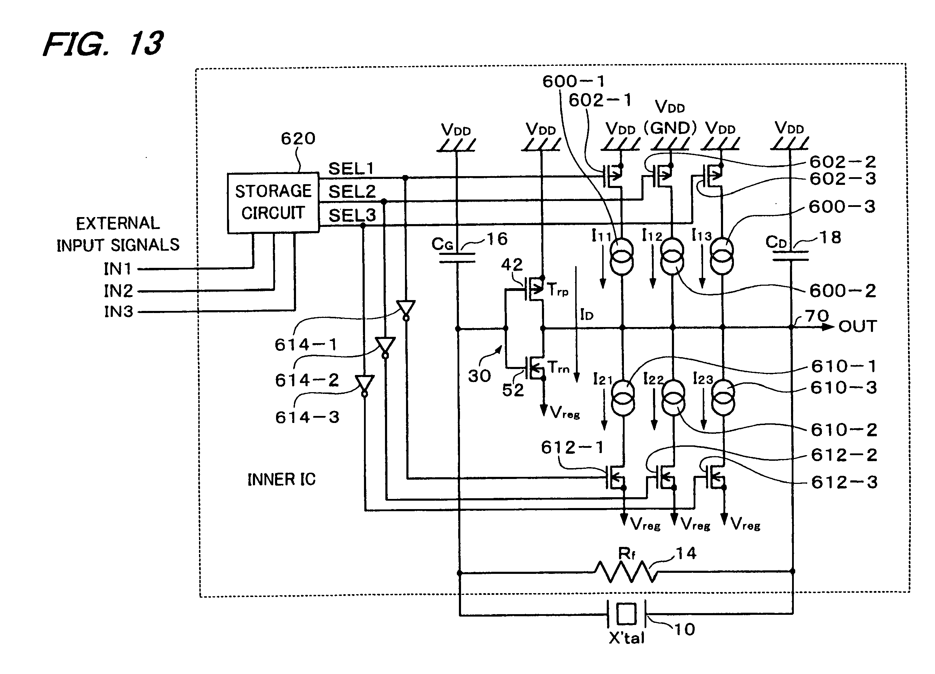

2.2 The present embodiment takes an arrangement of circuit shown in Fig. 13 so as to fully deal with fluctuations of the constant voltages $V_{reg}$ in oscillation circuits, which are produced in large quantities. In the embodiment, it is preferred to design the product, for example, such that the target constant voltage $V_{reg-B}$ is set to be between the absolute value of the minimum constant voltage required for stabilizing oscillation and the absolute value of the first constant voltage $V_{reg-MIN}$ smaller than the absolute value of said minimum constant voltage by the range of fluctuations $\Delta V_{reg}$ of the constant voltages in oscillation circuits which are produced in great quantities as shown in Fig. 14B.

According to the present embodiment, an oscillation circuit comprises a plurality of constant current sources 600-1, 600-2, 600-3, 610-1, 610-2 and 610-3 and a selection circuit for selecting one of the constant current sources. The current value in a constant current source that may stabilize oscillation is optimized during the IC producing step (inspection step) to provide the circuit shown in Fig. 1.

More particularly, a transistor 42 is connected in parallel to the first group of constant current sources 600-1, 600-2 and 600-3 while a transistor 52 is connected in parallel to the second group of constant current sources 610-1, 610-2 and 600-3.

The selection circuit comprises constant current source selection switching elements 602-1, 602-2, 602-3, 612-1, 612-2 and 612-3, each of which is connected in series to the respective one of the transistors 600-1, 600-2, 600-3, 610-1, 610-2 and 610-3.

A storage circuit 620 receives either of external input signals IN1, IN2 and IN3. The storage circuit 620 responds to the received external input signals to selectively output the corresponding one of said three selection signals SEL1, SEL2 and SEL3.

Each of the three selection signals SEL1, SEL2 and SEL3 output from the storage circuit 620 is then input into the corresponding one of the switching elements 602-1, 602-2 and 602-3 and also into the gate of the corresponding one of the switching elements 612-1, 612-2 and 612-3 through the corresponding one of inverters 614-1, 614-2 and 614-3.

Therefore, if the selection signal SEL1 is output, a pair of transistors 602-1 and 612-1 are turned on and a pair of constant current sources 600-1 and 610-1 are selected.

Similarly, if each of the selection signals SEL2 and SEL3 is output, another pair of constant current sources 600-2 and 610-2 or 600-3 and 610-3 are selected.

The detail of Fig. 13 will be described below.

The constant currents from the constant current sources 600-1, 600-2, 600-3, 610-1, 610-2 and 610-3 are set as follows:

$$I_{11} > I_{12} > I_{13} \text{ and } I_{21} > I_{22} > I_{23}.$$

In the IC inspection step, the drain current $I_D$ at the sub-threshold region is first measured.

From the result of measurement, if it is judged that the drain current $I_D$ required for stable oscillation is insufficient, an external signal for selecting a constant current source for supplying an additional current is input into the storage circuit 620. The external signal input into the storage circuit 620 may include IN1=Low level, IN2=High level and IN3=High level, for example. In response to such an input, the storage circuit 620 outputs SEL1=Low, SEL2=High and SEL3=High and selects the constant current sources having large currents.

If it is judged that the drain current $I_D$ is sufficiently large and an additional current is unnecessary for stable oscillation from the result of measurement, an external signal including IN1=High level, IN2=High level and IN3=High level is then input into the storage circuit 620. In response to such an input, the storage circuit 620 outputs SEL1=High, SEL2=High and SEL3=High and does not select the constant current sources 600 and 610.

In such a manner, the current value of the constant current source required for stable oscillation is optimized against fluctuations of the constant voltages in oscillation circuits which are produced in large quantities.

The circuit of Fig. 13 may select one of eight combinations of constant current sources 600 and 610. Further, three external input signals may be added so that the circuit may use six external input signals for individually selecting each of the constant current sources 600 and 610. (This is because the values $V_{TP}$ and $V_{TN}$ do not fluctuate in a single direction in oscillation circuits which are produced in large quantities.)

The circuits of Figs. 1 and 13 are similar for having the constant current sources 600 and 610, but are different from each other in the drain current characteristics at the sub-threshold regions of the Pch- and Nch-transistors depending on the IC producing process.

In such a case, an additional current required for stable oscillation may be supplied from either of the constant current source 600 or 610, if necessary.

The above embodiment has been described as to the oscillation circuit which comprises a plurality of constant current sources, each of which can be in turn selected during the IC inspection process. The oscillation circuit may only include a single constant current source, the capacity of which can be adjusted during the IC inspection process. For example, the back-gate effect in FET forming the constant current source may be utilized to change the threshold value in FET for controlling the value of the constant current supplied as the drain current.

The storage circuit 620 may be formed by EEPROM, ferroelectric memory, non-volatile memory, FUSE and laser-cutting type memory or the like.

(3) The relationship between $V_{TP}$ and $V_{TN}$ when they satisfy the above formulae (2) and (3) will be described below.

According to the first example and the first and second embodiments which will be described later, in the formulae (2) and (3), the values $V_{TP}$ and $V_{TN}$ may have either of the following relationships:

$$|V_{TP}| = |V_{TN}|$$

and

$$|V_{TP}| \neq |V_{TN}|.$$

With $|V_{TP}| \neq |V_{TN}|$, for example, the voltages for initiating and terminating oscillation may be reduced while satisfying the formulae (2) and (3).

3. Second Embodiment

The first embodiment have been described above as being configured in such a manner that the threshold voltages of the transistors 42 and 52 satisfy Equation (2) to reduce the short-circuiting current, by way of example. The present embodiment of the invention makes it possible to reduce the short-circuiting current of the inverting amplifier 30 in a manner similar to that of the example, by applying direct current (DC) bias voltages to the gates of the transistors 42 and 52, even when those transistors 42 and 52 are configured to satisfy the condition of Equation (1), as in the prior art.

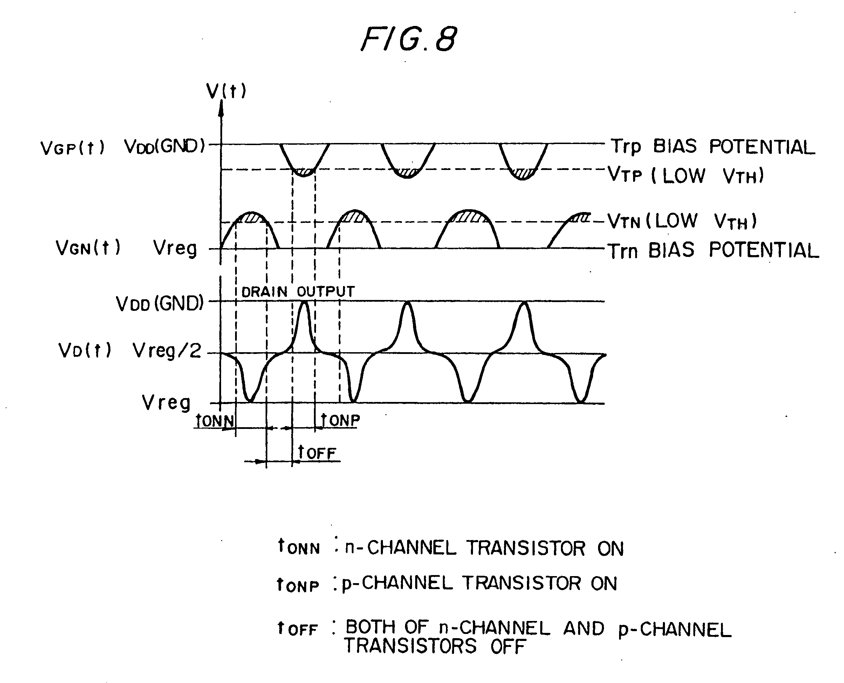

The crystal oscillation circuit of this embodiment is shown in Fig. 7 and a timing chart thereof is shown in Fig. 8. The arrangements of the constant current sources 600 and 610 and that of a selection circuit for selecting a constant current source as well as other arrangements described in the first embodiment are applicable to the present embodiment and therefore will not be discussed herein.

This crystal oscillation circuit comprises a first bias circuit 70 and a second bias circuit 80 that each cause a shift in the DC potential of the feedback input $V_{G(t)}$ of the inverting amplifier 30 that is input to the gates of the transistors 42 and 52.

These bias circuits 70 and 80 each comprises a capacitor 72 or 82 for removing the DC component, and a resistor 74 or 84 for applying a DC bias voltage.

The capacitors 72 and 82 are used to remove the DC component from the gate signal $V_{G(t)}$ and apply the resultant signal to the gates of the corresponding transistors 42 and 52.

The resistor 74 is connected between the gate of the transistor 42 and the ground potential $V_{DD}$, to pull the DC potential of the feedback input $V_{G(t)}$ that is input to the gate of the transistor 42 up to the ground potential $V_{DD}$.

The resistor 84 is connected between the gate of the transistor 52 and the power voltage $V_{reg}$, to pull the DC potential of the feedback input $V_{G(t)}$ that is input to the gate of the transistor 52 down to the power source potential $V_{reg}$.

The above configuration ensures that the gate signal $V_{G(t)}$ that is input as feedback to the inverting amplifier 30 is applied to the gates of the transistors 42 and 52 in states in which the DC potential thereof has been converted to $V_{DD}$ and the power source potential $V_{reg}$ by the first and second bias circuits 70 and 80, as indicated by $V_{GP(t)}$ and $V_{GN(t)}$.

There is therefore is no period of time at which both of the transistors 42 and 52 are on while the transistors 42 and 52 are being driven to turn on and off alternately, and, as a result, the short-circuiting current flowing through the inverting amplifier 30 is greatly reduced, in a similar manner to that of the example, making it possible to reduce the power consumption.

In particular, this embodiment makes it possible to reduce the short-circuiting currents even when the absolute values of the threshold voltages of the enhancement-mode transistors 42 and 52 are made smaller. As a result, the power voltage applied to the inverting amplifier 30 is smaller, which also helps to make it possible to reduce the power consumption.

Note that the bias voltages applied to the first and second bias circuits 70 and 80 could equally well be shifted in such a manner that the DC potentials of the feedback inputs to the gates of the transistors 42 and 52 are at potentials other than those of this embodiment, provided that the transistors 42 and 52 are not on simultaneously.

4. Other Embodiments

It should be noted that this invention is not limited to the above described embodiments, and it can be modified in various different ways within the range of the invention.

For example, the descriptions of the above embodiments are based on configurations in which each of the first and second circuits 40 and 50 had a single transistor, by way of example, but other configurations could be devised in which other circuit elements could be incorporated into the circuits if necessary, without causing any loss of function of the first and second circuits 40 and 50.

In addition, it is preferable that a semiconductor device is fabricated to comprise the crystal oscillation circuit of the above embodiments, or an electronic circuit that comprises such a crystal oscillation circuit, and this semiconductor device could be mounted in portable electronic equipment that has a restricted power source capacity, such as a portable telephone, a portable computer terminal, or any other type of portable equipment.

Furthermore, the descriptions of the above embodiments are based on the use of the crystal oscillation circuit in an electronic circuit for a timepiece, by way of example, but the present invention is not limited thereto. It has many other applications and is extremely effective when used in a wide range of portable electronic equipment that have restricted power source capacities, such as portable telephones, portable computer terminals, or any other type of portable equipment.

The embodiments have been described as to the crystal oscillation circuit having the crystal oscillator as a source of oscillation. The present invention may be applied similarly to a drive circuit (or driver) such as a piezoelectric motor which uses a piezoelectric element as an oscillator.

**Claims**

1. An oscillation circuit comprising:

a first semiconductor switching element (42) and a second semiconductor switching element (52) included in an inverting amplifier (30),

wherein the first and second semiconductor switching elements (42, 52) included in the inverting amplifier (30) are prevented from being on simultaneously to limit a short-circuiting current flowing through the inverting amplifier (30) when the oscillation circuit is driven,

wherein an OFF region in which the first and second semiconductor switching elements (42, 52) are turned off so that they are prevented from being on simultaneously includes a sub-threshold region in which a sub-threshold current flows, and

wherein at least one of the first and second semiconductor switching elements (42, 52) has connected a plurality of constant current sources (600-1 - 6003, 610-1 - 610-3) in parallel therewith, each constant current source supplying a different constant current;

the oscillation circuit further comprising a selection circuit for selecting a constant current source from the plurality of constant current sources (600-1 - 6003, 610-1 - 610-3), wherein a shortage of power necessary for stabilizing oscillation is compensated for by power from the selected constant current source.

2. The oscillation circuit as defined in claim 1, wherein the absolute value of the supply voltage of the inverting amplifier (30) is set to be equal to a minimum value of voltage necessary for stabilizing oscillation.

3. The oscillation circuit as defined in claim 1, wherein a target absolute value of the supply voltage of the inverting amplifier (30) is set to be between the absolute value of a minimum supply voltage of the inverting amplifier (30) necessary for stabilizing oscillation and the absolute value of a first supply voltage that is smaller than the absolute value of said minimum supply voltage by a range of fluctuations of supply voltages of inverting amplifiers in oscillation circuits which are produced in large quantities and wherein the selection circuit is adapted to select a constant current source based on supply voltages of inverting amplifiers in oscillation circuits which are produced in large quantities.

4. The oscillation circuit as defined in any one of claims 1 to 3, wherein a first group of constant current sources (600-1 - 600-3) is connected in parallel to the first semiconductor switching element (42), and a second group of constant current sources (610-1 - 610-3) is connected in parallel to the second semiconductor switching element (52), and wherein the selection circuit is adapted to select a respective constant current source from each group of constant current sources.

5. The oscillation circuit as defined in any one of claims 1 to 4, wherein the sum of the absolute values of the threshold voltages of the first and second semiconductor switching elements (42, 52) is set to be greater than or equal to the absolute value of the supply voltage of the inverting amplifier (30) to limit a short-circuiting current flowing through the inverting amplifier (30) when the oscillation circuit is driven.

6. The oscillation circuit as defined in any one of claims 1 to 4, further comprising a feedback circuit (10, 14) having a crystal resonator (14) connected between an output side and an input side of the inverting amplifier (30), for inverting the phase of the output signal from the inverting amplifier (30) and feeding the inverted signal back to the inverting amplifier (30) as an input signal;

wherein the inverting amplifier (30) comprises a first circuit including the first semiconductor switching element (42), and a second circuit including the second semiconductor switching element (52);

wherein the first semiconductor switching element (42) is connected to a side of a first potential (VDD) and is driven to be turned on and off by the feedback input signal, to excite the crystal oscillator; and

wherein the second semiconductor switching element (52) is connected to a side of a second potential ($V_{reg}$) that differs from the first potential ($V_{DD}$) and is driven to be turned on and off by the feedback input signal at a timing that differs from that of the first semiconductor switching element (42), to excite the crystal oscillator.

7. The oscillation circuit as defined in claim 5 or 6, wherein the sum of the absolute values of the threshold voltages of the first and second semiconductor switching elements (42, 52) is set to be greater than or equal to the absolute value of the supply voltage of the inverting amplifier (30) to satisfy the following formula

$$|V_{reg}| \leq |V1| + |V2|$$

where |V1| is the absolute value of the threshold voltage of the first semiconductor switching element (42); |V2| is the absolute value of the threshold voltage of the second semiconductor switching element (52); and $|V_{reg}|$ is the absolute value of the supply voltage of the inverting amplifier (30), and

wherein the absolute values of the threshold voltages of the first and second semiconductor switching elements (42, 52) are set to be smaller than the absolute value of the supply voltage of the inverting amplifier (30) as represented by the following formulae

$$|V_{reg}| > |V1|$$

and

$$|V_{reg}| > |V2|.$$

8. The oscillation circuit as defined in any one of claims 1 to 4, further comprising:

a bias circuit (70, 80) for applying a first direct current bias voltage and a second direct current bias voltage to the gate of the first semiconductor switching element (42) and that of the second semiconductor switching element (52), respectively;

the first and second bias voltages shifting values of the direct current potentials of feedback inputs signals that are input from the inverting amplifier (30) to the gates of the first and second semiconductor switching elements (42, 52), to prevent the first and second semiconductor switching elements (42, 52) from being on simultaneously.

9. The oscillation circuit as defined in any one of claims 1 to 4, further comprising a feedback circuit (10, 14) having a crystal resonator (14) connected between an output side and an input side of the inverting amplifier (30), for inverting the phase of the output signal from the inverting amplifier (30) and feeding the inverted signal back to the inverting amplifier (30) as an input signal; and

a bias circuit (70, 80) for applying a direct current bias voltage to the inverting amplifier (30);

wherein the inverting amplifier (30) comprises:

a first circuit being connected to a side of a first potential ($V_{DD}$) and including the first semiconductor switching element (42); and

a second circuit being connected to a side of a second potential ($V_{reg}$) that differs from the first potential ($V_{DD}$) and including the second semiconductor switching element (52);

wherein the first semiconductor switching element (42) is connected to a side of the first potential ($V_{DD}$) and is driven to be turned on and off by the feedback input signal that is input to its gate, to excite the crystal oscillator;

wherein the second semiconductor switching element (52) is connected to a side of the second potential ($V_{reg}$) and is driven to be turned on and off by the feedback input signal that is input to its gate at a timing that differs from that of the first semiconductor switching element (42), to excite the crystal oscillator;

wherein the bias circuit (70, 80) comprises:

- a first bias circuit (70) for applying a first direct current bias voltage to the gate of the first semiconductor switching element (42); and
- a second bias circuit (80) for applying a second direct current bias voltage to the gate of said second semiconductor switching element (52); and

wherein the first and second bias voltages shift values of the direct current potentials of feedback input signals that are input from the inverting amplifier (30) to the gates of said first and second semiconductor switching elements (42, 52), to prevent the first and second semiconductor switching elements (42, 52) from being on simultaneously.

10. The oscillation circuit as defined in claim 9, wherein the first bias voltage is set to said first potential ($V_{DD}$) and wherein the second bias voltage is set to said second potential ($V_{reg}$).

11. The oscillation circuit as defined in any one of claims 1 to 10, wherein the first and second semiconductor switching elements (42, 52) are configured by using field-effect transistor elements of different conductivity types.

12. The oscillation circuit as defined in any one of claims 1 to 11, wherein the oscillation circuit uses a crystal oscillator having a high Q value, the Q value being an index representing the degree of easiness in mechanical oscillation.

13. The oscillation circuit as defined in claim 12, wherein the Q value is equal to or higher than 10,000 and expressed by the following equation

$$Q = \alpha/Rxt$$

where Rxt is a component of resistance in the crystal oscillator and $\alpha$ is a coefficient.

14. The oscillation circuit as defined in any one of claims 1 to 13, wherein a threshold voltage $V_T$ of each of the first and second semiconductor switching elements (42, 52) that functions as a gate voltage for inverting a conduction type of a silicon crystal is represented by the following

$$V_T = 2\varphi_E + [2 \cdot \varepsilon_S \cdot q \cdot N_A \cdot (2\varphi_E)]^{1/2} / (\varepsilon_S /d)$$

where $\varphi_E$ is the Fermi potential, $\varepsilon_S$ is $\varepsilon si$ (the relative dielectric constant of silicon) multiplied by $\varepsilon 0$ (the dielectric constant of vacuum), q is the electron charge, $N_A$ is the concentration of a substrate and d is the thickness of an oxide film.

15. An electronic circuit comprising the oscillation circuit as defined in any one of claims 1 to 14.

16. A semiconductor device comprising the oscillation circuit as defined in any one of claims 1 to 14.

17. An electronic equipment comprising the oscillation circuit as defined in any one of claims 1 to 14.

18. A timepiece comprising the oscillation circuit as defined in any one of claims 1 to 14.

**Patentansprüche**

1. Oszillatorschaltung, die aufweist:

   ein erstes Halbleiterschaltelement (42) und ein zweites Halbleiterschaltelement (52), die in einem invertierenden Verstärker (30) enthalten sind,
   wobei das erste und zweite Halbleiterschaltelement (42, 52), die in dem invertierenden Verstärker (30) enthalten sind, daran gehindert werden, gleichzeitig an zu sein, um einen Kurzschluss-Stromfluss durch den invertierenden Verstärker (30) zu begrenzen, wenn die Oszillatorschaltung angesteuert wird,
   wobei ein AUS-Bereich, in dem die ersten und zweiten Halbleiterschaltelemente (42, 52) ausgeschaltet sind, um so daran gehindert zu werden, gleichzeitig an zu sein, einen Unter-Schwellenbereich umfasst, in dem ein Unter-Schwellenstrom fließt, und
   wobei zumindest eines der ersten und zweiten Halbleiterschaltelemente (42, 52) eine Vielzahl von Konstantstromquellen (600-1 - 6003; 610-1 - 610-3) parallel dazu verbunden hat, wobei jede Konstantstromquelle einen anderen Konstantstrom liefert;
   wobei die Oszillatorschaltung weiter eine Auswahlschaltung aufweist zum Auswählen einer Konstantstromquelle aus der Vielzahl von Konstantstromquellen (600-1 - 6003; 610-1 - 610-3), wobei ein Fehlen von Leistung, die zum Stabilisieren einer Oszillation erforderlich ist, durch Leistung von der ausgewählten Konstantstromquelle kompensiert wird.

2. Oszillatorschaltung gemäß Anspruch 1, wobei der absolute Wert der Versorgungsspannung des invertierenden Verstärkers (30) gleich gesetzt ist zu einem Minimalwert einer Spannung, die zum Stabilisieren einer Oszillation erforderlich ist.

3. Oszillatorschaltung gemäß Anspruch 1, wobei ein absoluter Zielwert der Versorgungsspannung des invertierenden Verstärkers (30) gesetzt ist zwischen dem absoluten Wert einer Minimum-Versorgungsspannung des invertierenden Verstärkers (30), die zum Stabilisieren einer Oszillation erforderlich ist, und dem absoluten Wert einer ersten Versorgungsspannung, die kleiner ist als der absolute Wert der Minimum-Versorgungsspannung, durch einen Bereich von Fluktuationen von Versorgungsspannungen von invertierenden Verstärkern in Oszillatorschaltungen, die in großen Mengen erzeugt werden, und wobei die Auswahlschaltung ausgebildet ist, eine Konstantstromquelle auszuwählen basierend auf Versorgungsspannungen von invertierenden Verstärkern in Oszillatorschaltungen, die in großen Mengen erzeugt werden.

4.  Oszillatorschaltung gemäß einem der Ansprüche 1 bis 3, wobei eine erste Gruppe von Konstantstromquellen (600-1 - 600-3) mit dem ersten Halbleiterschaltelement (42) parallel verbunden ist und eine zweite Gruppe von Konstantstromquellen (610-1 - 610-3) mit dem zweiten Halbleiterschaltelement (52) parallel verbunden ist, und wobei die Auswahlschaltung ausgebildet ist, eine jeweilige Konstantstromquelle aus jeder Gruppe von Konstantstromquellen auszuwählen.

5.  Oszillatorschaltung gemäß einem der Ansprüche 1 bis 4, wobei die Summe der absoluten Werte der Schwellenspannungen der ersten und zweiten Halbleiterschaltelemente (42, 52) größer oder gleich gesetzt ist als der absolute Wert der Versorgungsspannung des invertierenden Verstärkers (30), um einen Kurzschlussstrom zu begrenzen, der durch den invertierenden Verstärker (30) fließt, wenn die Oszillatorschaltung angesteuert wird.

6.  Oszillatorschaltung gemäß einem der Ansprüche 1 bis 4, die weiter aufweist eine Feedback-Schaltung (10, 14), die einen Quarzresonator (14) hat, verbunden zwischen einer Ausgangsseite und einer Eingangsseite des invertierenden Verstärkers (30), zum Invertieren der Phase des Ausgangssignals von dem invertierenden Verstärker (30) und Zuführen des invertierten Signals zurück zu dem invertierenden Verstärker (30) als ein Eingangssignal;
    wobei der invertierende Verstärker (30) eine erste Schaltung aufweist, die das erste Halbleiterschaltelement (42) umfasst, und eine zweite Schaltung, die das zweite Halbleiterschaltelement (52) umfasst;
    wobei das erste Halbleiterschaltelement (42) mit einer Seite eines ersten Potentials ($V_{DD}$) verbunden ist und angesteuert wird, um an- und abgeschaltet zu werden durch das Feedback-Eingangssignal, um den Quarzoszillator anzuregen; und
    wobei das zweite Halbleiterschaltelement (52) mit einer Seite eines zweiten Potentials (Vreg) verbunden ist, das sich von dem ersten Potential ($V_{DD}$) unterscheidet, und angesteuert wird, um an- und abgeschaltet zu werden durch das Feedback-Eingangssignal zu einem Zeitpunkt, der sich von dem des ersten Halbleiterschaltelements (42) unterscheidet, um den Quarzoszillator anzuregen.

7.  Oszillatorschaltung gemäß Anspruch 5 oder 6, wobei die Summe der absoluten Werte der Schwellenspannungen der ersten und zweiten Halbleiterschaltelemente (42, 52) größer oder gleich gesetzt ist zu dem absoluten Wert der Versorgungsspannung des invertierenden Verstärkers (30), um die folgende Formel zu erfüllen

$$|V_{reg}| \leq |V1| + |V2|$$

wobei |V1| der absolute Wert der Schwellenspannung des ersten Halbleiterschaltelements (42) ist; |V2| der absolute Wert der Schwellenspannung des zweiten Halbleiterschaltelements (52) ist; und |Vreg| der absolute Wert der Versorgungsspannung des invertierenden Verstärkers (30) ist, und
wobei die absoluten Wert der Schwellenspannungen der ersten und zweiten Halbleiterschaltelemente (42, 52) kleiner gesetzt sind als der absolute Wert der Versorgungsspannung des invertierenden Verstärkers (30), wie durch die folgenden Formeln repräsentiert

$$|V_{reg}| > |V1|$$

und

$$|V_{reg}| > |V2|.$$

8.  Oszillatorschaltung gemäß einem der Ansprüche 1 bis 4, die weiter aufweist:

eine Bias-Schaltung (70, 80) zum Anwenden einer ersten Gleichstrom-Bias-Spannung und einer zweiten Gleichstrom-Bias-Spannung auf das Gate des ersten Halbleiterschaltelements (42) beziehungsweise das des zweiten Halbleiterschaltelements (52);

wobei die ersten und zweiten Bias-Spannungen Werte der Gleichstrom-Potentiale der Feedback-Eingangssignale, die von dem invertierenden Verstärker (30) an die Gates der ersten und zweiten Halbleiterschaltelemente (42, 52) eingegeben werden, verschieben, um zu verhindern, dass die ersten und zweiten Halbleiterschaltelemente (42, 52) gleichzeitig eingeschaltet sind.

9. Oszillatorschaltung gemäß einem der Ansprüche 1 bis 4, die weiter aufweist eine Feedback-Schaltung (10, 14), die einen Quarzresonator (14) hat, verbunden zwischen einer Ausgangsseite und einer Eingangsseite des invertierenden Verstärkers (30), zum Invertieren der Phase des Ausgangssignals von dem invertierenden Verstärker (30) und Zuführen des invertierten Signals zurück zu dem invertierenden Verstärker (30) als ein Eingangssignal; und

eine Bias-Schaltung (70, 80) zum Anlegen einer Gleichstrom-Bias-Spannung auf den invertierenden Verstärker (30);

wobei der invertierende Verstärker (30) aufweist:

eine erste Schaltung, die mit einer Seite eines ersten Potentials ($V_{DD}$) verbunden ist und das erste Halbleiterschaltelement (42) umfasst; und

eine zweite Schaltung, die mit einer Seite eines zweiten Potentials (Vreg) verbunden ist, das sich von dem ersten Potential ($V_{DD}$) unterscheidet, und das zweite Halbleiterschaltelement (52) umfasst;

wobei das erste Halbleiterschaltelement (42) mit einer Seite des ersten Potentials ($V_{DD}$) verbunden ist und angesteuert wird, um an- und abgeschaltet zu werden, durch das Feedback-Eingangssignal, das in dessen Gate eingegeben wird, um den Quarzoszillator anzuregen; und

wobei das zweite Halbleiterschaltelement (52) mit einer Seite des zweiten Potentials ($V_{reg}$) verbunden ist und angesteuert wird, um an- und abgeschaltet zu werden, durch das Feedback-Eingangssignal, das in dessen Gate eingegeben wird, zu einem Zeitpunkt, der sich von dem des ersten Halbleiterschaltelements (42) unterscheidet, um den Quarzoszillator anzuregen;

wobei die Bias-Schaltung (70, 80) aufweist:

- eine erste Bias-Schaltung (70) zum Anlegen einer ersten Gleichstrom-Bias-Spannung auf das Gate des ersten Halbleiterschaltelements (42); und
- eine zweite Bias-Schaltung (80) zum Anlegen einer zweiten Gleichstrom-Bias-Spannung auf das Gate des zweiten Halbleiterschaltelements (52); und

wobei die ersten und zweiten Bias-Spannungen Werte der Gleichstrom-Potentiale der Feedback-Eingangssignale, die von dem invertierenden Verstärker (30) an die Gates der ersten und zweiten Halbleiterschaltelemente (42, 52) eingegeben werden, verschieben, um zu verhindern, dass die ersten und zweiten Halbleiterschaltelemente (42, 52) gleichzeitig eingeschaltet sind.

10. Oszillatorschaltung gemäß Anspruch 9, wobei die erste Bias-Spannung auf das erste Potential ($V_{DD}$) gesetzt ist und wobei die zweite Bias-Spannung auf das zweite Potential ($V_{reg}$) gesetzt ist.

11. Oszillatorschaltung gemäß einem der Ansprüche 1 bis 10, wobei die ersten und zweiten Halbleiterschaltelemente (42, 52) konfiguriert sind unter Verwendung von Feldeffekttransistorelementen unterschiedlicher Leitfähigkeitstypen.

12. Oszillatorschaltung gemäß einem der Ansprüche 1 bis 11, wobei die Oszillatorschaltung einen Quarzoszillator mit einem hohen Q-Wert verwendet, wobei der Q-Wert ein Index ist, der den Grad von Leichtigkeit in einer mechanischen Oszillation repräsentiert.

13. Oszillatorschaltung gemäß Anspruch 12, wobei der Q-Wert gleich oder höher ist als 10 000 und durch die folgende Gleichung ausgedrückt wird

$$Q = \alpha/Rxt$$

wobei Rxt eine Widerstands-Komponente in dem Quarzoszillator ist und $\alpha$ ein Koeffizient ist.

14. Oszillatorschaltung gemäß einem der Ansprüche 1 bis 13, wobei eine Schwellenspannung $V_T$ von jedem der ersten und zweiten Halbleiterschaltelemente (42, 52), die als eine Gate-Spannung zum Invertieren eines Leitungstyps eines Siliziumkristalls funktioniert, durch Folgendes repräsentiert wird

$$V_T = 2\varphi_E + [2 \cdot \varepsilon_s \cdot q \cdot N_A \cdot (2\varphi_E)]^{1/2} / (\varepsilon_s/d)$$

wobei $\varphi_E$ das Fermi-Potential ist, $\varepsilon_S$ εsi (die relative Dielektrizitätskonstante von Silizium) ist multipliziert mit ε0 (die Dielektrizitätskonstante von Vakuum), q die Elektronenladung ist, NA die Konzentration eines Substrats ist und d die Dicke eines Oxidfilms ist.

**15.** Elektronische Schaltung, die die Oszillatorschaltung gemäß einem der Ansprüche 1 bis 14 aufweist.

**16.** Halbleitervorrichtung, die die Oszillatorschaltung gemäß einem der Ansprüche 1 bis 14 aufweist.

**17.** Elektronische Ausrüstung, die die Oszillatorschaltung gemäß einem der Ansprüche 1 bis 14 aufweist.

**18.** Zeitmesser, der die Oszillatorschaltung gemäß einem der Ansprüche 1 bis 14 aufweist.

**Revendications**

**1.** Circuit oscillant comprenant :

un premier élément (42) de commutation à semiconducteur et un deuxième élément (52) de commutation à semiconducteur compris dans un amplificateur (30) inverseur,
dans lequel le premier et le deuxième éléments (42, 52) de commutation à semiconducteur compris dans l'amplificateur (30) inverseur sont empêchés d'être fermés simultanément pour limiter un courant de court-circuit passant dans l'amplificateur (30) inverseur lorsque le circuit oscillant est excité.
dans lequel une région ouverte, dans laquelle les premiers éléments (42, 52) de commutation à semiconducteur sont ouverts, de sorte qu'ils sont empêchés d'être fermés simultanément, comprend une région de sous-seuil, dans laquelle un courant de sous-seuil passe, et
dans lequel au moins l'un des premier et deuxième éléments (42, 52) de commutation à semiconducteur est connecté à une pluralité de sources (600-1 à 6003, 610-1 à 610-3) de courant constant en parallèle avec eux, chaque source de courant constant fournissant un courant constant différent ;
le circuit oscillant comprenant en outre un circuit de sélection pour sélectionner une source de courant constant parmi la pluralité de sources (600-1 à 6003, 610-1 à 610-3) de courant constant, dans lequel un manque de courant nécessaire pour stabiliser l'oscillation est compensé par du courant provenant de la source de courant constant sélectionnée.

**2.** Circuit oscillant tel que défini à la revendication 1, dans lequel la valeur absolue de la tension d'alimentation de l'amplificateur (30) inverseur est réglée de manière à être égale à une valeur minimum de tension nécessaire pour stabiliser l'oscillation.

**3.** Circuit oscillant tel que défini à la revendication 1, dans lequel une valeur absolue cible de la tension d'alimentation de l'amplificateur (30) inverseur est fixée de manière à être comprise entre la valeur absolue d'une tension d'alimentation minimum de l'amplificateur (30) inverseur nécessaire pour stabiliser l'oscillation et la valeur absolue d'une première tension d'alimentation, qui est plus petite que la valeur absolue de la tension d'alimentation minimum d'une plage de fluctuation des tensions d'alimentation d'amplificateurs inverseurs dans des circuits oscillants qui sont produits en grande quantité et dans lequel le circuit de sélection est conçu pour sélectionner une source de courant constant sur la base des tensions d'alimentation d'amplificateurs inverseurs dans des circuits oscillants qui sont produits en grande quantité.

**4.** Circuit oscillant tel que défini suivant l'une quelconque des revendications 1 à 3, dans lequel un premier groupe de sources (600-1 à 600-3) de courant constant est monté en parallèle au premier élément (42) de commutation à semiconducteur et un deuxième groupe de sources (610-1 à 610-3) de courant constant est monté en parallèle au deuxième élément (52) de commutation à semiconducteur et dans lequel le circuit de sélection est conçu pour sélectionner une source de courant constant respective parmi chaque groupe de sources de courant constant.

**5.** Circuit oscillant tel que défini suivant l'une quelconque des revendications 1 à 4, dans lequel la somme des valeurs absolues des tensions de seuil des premier et deuxième éléments (42, 52) de commutation à semiconducteur est réglée de manière à être supérieure ou égale à la valeur absolue de la tension d'alimentation de l'amplificateur (30) inverseur, pour limiter un courant de court-circuit passant dans l'amplificateur (30) inverseur lorsque le circuit oscillant est excité.

**6.** Circuit oscillant tel que défini suivant l'une quelconque des revendications 1 à 4, comprenant en outre un circuit (10, 14) de réaction ayant un résonateur (14) à cristal monté entre un côté de sortie et un côté d'entrée de l'amplificateur (30) inverseur, pour inverser la phase du signal de sortie de l'amplificateur (30) inverseur et renvoyer le signal inversé à l'amplificateur (30) inverseur en tant que signal d'entrée ;
dans lequel l'amplificateur (30) inverseur comprend un premier circuit comportant le premier élément (42) de commutation à semiconducteur et un deuxième circuit comportant le deuxième élément (52) de commutation à semiconducteur ;
dans lequel le premier élément (42) de commutation à semiconducteur est relié à un côté d'un premier potentiel (VDD) et est commandé pour être fermé et ouvert par le signal d'entrée de réaction, pour exciter l'oscillateur à cristal ; et
dans lequel le deuxième élément (52) de commutation à semiconducteur est relié à un côté d'un deuxième potentiel ($V_{reg}$) qui diffère du premier potentiel ($V_{DD}$) et est commandé pour être fermé et ouvert par le signal d'entrée de réaction à une cadence qui diffère de celle du premier élément (42) de commutation à semiconducteur, pour exciter l'oscillateur à cristal.

**7.** Circuit oscillant tel que défini suivant la revendication 5 ou 6, dans lequel la somme des valeurs absolues des tensions de seuil des premier et deuxième éléments (42, 52) de commutation à semiconducteur est réglée de manière à être supérieure ou égale à la valeur absolue de la tension d'alimentation de l'amplificateur (30) inverseur, pour satisfaire la formule suivante

$$|Vreg| \leq |V1| + |V2|$$

dans lequel |V1| est la valeur absolue de la tension de seuil du premier élément (42) de commutation à semiconducteur ; |V2| est la valeur absolue de la tension de seuil du deuxième élément (52) de commutation à semiconducteur ; et $|V_{reg}|$ est la valeur absolue de la tension d'alimentation de l'amplificateur (30) inverseur, et dans lequel les valeurs absolues de tension de seuil des premier et deuxième éléments (42, 52) de commutation à semiconducteur sont réglées de manière à être plus petites que la valeur absolue de la tension d'alimentation d'amplificateur (30) inverseur, tel que représenté par les formules suivantes

$$|V_{reg}| > |V1|$$

et

$$|Vreg| > |V2|.$$

**8.** Circuit oscillant tel que défini suivant l'une quelconque des revendications 1 à 4, comprenant en outre :

un circuit (70, 80) de polarisation, pour appliquer une première tension de polarisation en courant continu et une deuxième tension de polarisation en courant continu à la grille du premier élément (42) de commutation à semiconducteur et à celle du deuxième élément (52) de commutation à semiconducteur respectivement ;
des première et deuxième tensions de polarisation décalant des valeurs des potentiels en courant continu des signaux d'entrée de réaction qui sont envoyés de l'amplificateur (30) inverseur aux grilles des premier et deuxième éléments (42, 52) de commutation à semiconducteur, pour empêcher les premier et deuxième éléments (42, 52) de commutation à semiconducteur d'être fermés simultanément.

**9.** Circuit oscillant tel que défini suivant l'une quelconque des revendications 1 à 4, comprenant en outre un circuit (10, 14) de réaction ayant un résonateur (14) à cristal monté entre un côté de sortie et un côté d'entrée de l'amplificateur (30) inverseur, pour inverser la phase du signal de sortie sortant de l'amplificateur (30) inverseur et pour retourner le signal inversé à l'amplificateur (30) inverseur, en tant que le signal d'entrée ; et

un circuit (70, 80) de polarisation, pour appliquer une tension de polarisation au courant continu à l'amplificateur (30) inverseur ;

dans lequel l'amplificateur (30) inverseur comprend :

un premier circuit relié à un côté d'un premier potentiel ($V_{DD}$) et comprenant le premier élément (42) de commutation à semiconducteur ; et

un deuxième circuit relié à un côté d'un deuxième potentiel ($V_{reg}$) qui diffère du premier potentiel ($V_{DD}$) et comprenant le deuxième élément (52) de commutation à semiconducteur ;

dans lequel le premier élément (42) de commutation à semiconducteur est relié à un côté du premier potentiel ($V_{DD}$) et est commandé pour être ouvert et fermé par le signal d'entrée de réaction qui est envoyé à sa grille pour exciter l'oscillateur à cristal ;

dans lequel le deuxième élément (52) de commutation à semiconducteur est relié à un côté du deuxième potentiel ($V_{reg}$) et est commandé pour être fermé et ouvert par le signal d'entrée de réaction qui est envoyé à sa grille à une cadence qui diffère de celle du premier élément (42) de commutation à semiconducteur, pour exciter l'oscillateur à cristal ;

dans lequel le circuit (70, 80) de polarisation comprend :

- un premier circuit (70) de polarisation, pour appliquer une tension de polarisation en courant continu à la grille du premier élément (42) de commutation à semiconducteur ; et
- un deuxième circuit (80) de polarisation, pour appliquer une deuxième tension de polarisation en courant continu à la grille du deuxième élément (52) de commutation à semiconducteur ; et

dans lequel les première et deuxième tensions de polarisation décalent des valeurs des potentiels en courant continu des signaux d'entrée de réaction, qui sont envoyés de l'amplificateur (30) inverseur aux grilles des premier et deuxième éléments (42, 52) de commutation à semiconducteur, pour empêcher les premier et deuxième éléments (42, 52) de commutation à semiconducteur d'être fermés simultanément.

**10.** Circuit oscillant tel que défini suivant la revendication 9, dans lequel la première tension de polarisation est réglée audit premier potentiel ($V_{DD}$) et dans lequel la deuxième tension de polarisation est réglé audit deuxième potentiel ($V_{reg}$).

**11.** Circuit oscillant tel que défini suivant l'une quelconque des revendications 1 à 10, dans lequel le premier et le deuxième éléments (42, 52) de commutation à semiconducteur sont configurés en utilisant des éléments de transistor à effet de champ de type de conductivité différent.

**12.** Circuit oscillant tel que défini suivant l'une quelconque des revendications 1 à 11, dans lequel le circuit oscillant utilise un oscillateur à cristal ayant une grande valeur de Q, la valeur de Q étant un indice représentant le degré de facilité à osciller mécaniquement.

**13.** Circuit oscillant tel que défini suivant la revendication 12, dans lequel la valeur de Q est supérieure ou égale à 10,000 et est exprimée par l'équation suivante

$$Q = α/Rxt$$

dans laquelle Rxt est une composante de résistance de l'oscillateur à cristal et $α$ est un coefficient.

**14.** Circuit oscillant tel que défini suivant l'une quelconque des revendications 1 à 13, dans lequel une tension $V_T$ de seuil de chacun des premier et deuxième éléments (42, 52) de commutation à semiconducteur qui sert de tension de grille pour inverser un type de conduction d'un cristal de silicium est représentée par ce qui suit

$$V_T = 2φ_E + [2.ε_S . q . N_A . (2φ_E)]^{1/2} /(ε_S/d)$$

dans lequel $φ_E$ est le potentiel de Fermi, $ε_S$ est $ε_{si}$ (constante diélectrique relative du silicium) multiplié par $ε0$ (constante diélectrique du vide), q est la charge d'un électron, $N_A$ est la concentration d'un substrat et d est l'épaisseur d'un film d'oxyde.

**15.** Circuit électronique comprenant le circuit oscillant tel que défini dans l'une quelconque des revendications 1 à 14.

**16.** Dispositif à semiconducteur comprenant le circuit oscillant tel que défini suivant l'une quelconque des revendications 1 à 14.

**17.** Equipement électronique comprenant un circuit oscillant tel que défini suivant l'une quelconque des revendications 1 à 14.

**18.** Mouvement d'horlogerie comprenant le circuit oscillant tel que défini suivant l'une quelconque des revendications 1 à 14.

## FIG. 1

## FIG. 2
## PRIOR ART

## FIG. 3

## FIG.4
## PRIOR ART

$|Vreg| > |V_{TP}| + |V_{TN}|$

$V_{DD}$

$V_{TP}$

$V_{TN}$

$Vreg$

} SHORT-CIRCUITING PERIOD

$(|Vreg| - |V_{TP}| - |V_{TN}|)$

## FIG.5

$|Vreg| \leqq |V_{TP}| + |V_{TN}|$

$V_{DD}$

$V_{TN}$

OFF - OFF

$V_{TP}$

$Vreg$

} OFF-OFF PERIOD

$(|V_{TP}| + |V_{TN}| - |Vreg|)$

## FIG.6

## FIG.7

FIG.8

tONN : n-CHANNEL TRANSISTOR ON

tONP : p-CHANNEL TRANSISTOR ON

tOFF : BOTH OF n-CHANNEL AND p-CHANNEL
TRANSISTORS OFF

## FIG. 9

## FIG. 10

## FIG. 11

## FIG. 12

# FIG. 13

EP 1 176 719 B1

## FIG. 14A

SHORTAGE OF POWER SUPPLY
(SELECTION OF CONSTANT CURRENTS)

EXCESS POWER SUPPLY
(CUT OFF OF CONSTANT CURRENTS)

$V_{reg}$-A
(MINIMUM VALUE OF $V_{reg}$ NECESSARY
FOR STABLE OSCILLATION)

$V_{reg}$-min
(MINIMUM VALUE OF $V_{reg}$)

$V_{reg}$-max
(MAXIMUM VALUE OF $V_{reg}$)

$\Delta V_{reg}$
(FLUCTUATIONS OF CONSTANT VOLTAGES
IN OSCILLATION CIRCUITS PRODUCED IN
LARGE QUANTITIES)

## FIG. 14B

SHORTAGE OF POWER SUPPLY
(SELECTION OF CONSTANT CURRENTS)

$V_{reg}$-A
(MINIMUM VALUE OF $V_{reg}$ NECESSARY
FOR STABLE OSCILLATION)

$V_{reg}$-min
(MINIMUM VALUE OF $V_{reg}$)

$V_{reg}$-B
(TARGET VALUE)

$V_{reg}$-max
(MAXIMUM VALUE OF $V_{reg}$)

$\Delta V_{reg}$
(FLUCTUATIONS OF CONSTANT VOLTAGES
IN OSCILLATION CIRCUITS PRODUCED IN
LARGE QUANTITIES)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9087763 A
- US 3979698 A